# EUROPEAN PATENT APPLICATION

(11) **EP 2 853 682 A1**
(43) Date of publication of application: **01.04.2015**
(21) Application number: 13185892.0
(22) Date of filing: 25.09.2013
(51) Int. Cl.: E21B 41/00, E21B 47/01

(54) **Subsea enclosure system for disposal of generated heat**

(71) Applicant: Siemens Aktiengesellschaft, 80333 München (DE)
(72) Inventor: Kristensen, Knut Schonhowd, 7012 Trondheim (NO); Wigestrand, Baard Jonas, 7048 Trondheim (NO)

(57) **Abstract**

The invention relates to a subsea enclosure system comprising an enclosure adapted to maintain a predetermined pressure inside the enclosure (3) when the system is deployed under water; a heat generating electronic component (1) arranged in the enclosure; and a non-fluid block (2) comprising an electrically insulating, thermally conductive material which is at at least one surface (5) in direct contact with the heat generating electronic component and at another surface (4) in contact with the inner surface of one or more walls of the pressure resistant enclosure, enabling the non-fluid transfer of heat from the electronic component to the wall of the enclosure when the subsea enclosure system is operating.

## Description

### Field of the invention

The invention relates to subsea electronic components, particularly disposal of the heat generated by subsea electronic components inside of subsea canisters or enclosures.

### Background

In subsea production facilities and subsea electronics more generally, disposal of heat generated during operation of an electronic component is a problem. Subsea circuits, electronics and power components can produce vast amounts of excessive heat during operation. Failure to efficiently dispose of this heat results in heightened temperatures of the environment surrounding the electronic component, further leading to reduced performance of the electronic component as well as shortened expected useful lifetime.

In subsea applications, the electronic component is typically housed in a canister or other enclosure, and the excessive heat it generates remains inside the canister until it is transported from the electronic component through the canister wall and into the surrounding seawater. Currently, the subsea canisters are filled with a fluid, either a gas or a liquid, separating the electronic component from the canister wall. However, as the fluid does not serve as an efficient medium for heat transport, the temperature of the fluid and thus of the environment surrounding the electronic component increases. This temperature increase is potentially damaging for the electronic component and reduces its useful life expectancy. Coping with more frequent maintenance and replacement of overheated electronic components is costly and time-consuming. A solution that avoids elevated temperatures inside the canister by efficiently disposing of heat generated by a subsea electronic component would therefore be beneficial.

For solving the above problem, solutions are known which make use of a heat sink for improving the heat conduction into the surrounding sea water. Although such solutions improve the cooling of a heat generating electronic component, the operating temperature still remains relatively high, and a further improvement of the heat transfer is desirable.

Active cooling systems employing fans, pumps and the like generally suffer from the drawback that they are complex and costly to implement. Further, they are prone to failure, in particular over the expected lifetime of such subsea system which can exceed 25 years. It is desirable to keep the system relatively simple and cost efficient. Also, it is desirable to provide a system with a relatively long lifetime and long service intervals.

### Summary

Accordingly, there is a need to improve the cooling of an electronic component in a subsea enclosure.

This need is met by the features of the independent claims. The dependent claims describe embodiments of the invention.

According to an embodiment of the invention, a subsea enclosure system is provided which comprises an enclosure adapted to maintain a predetermined pressure inside the enclosure when the system is deployed under water; a heat generating electronic component arranged in the enclosure, the electronic component generating heat in operation; and a non-fluid block comprised of an electrically insulating, thermally conductive material which is at at least one surface in direct contact with the heat generating electronic component and at another surface in direct contact with the inner surface of at least one wall of the enclosure, so as to enable the non-fluid transfer of heat from the heat generating electronic component to the at least one wall of the enclosure when the subsea enclosure system is deployed under water in an operating state.

In one embodiment of the invention, the enclosure may be a pressure resistant enclosure. A pressure resistant enclosure offers the advantage that the pressure inside the enclosure remains approximately atmospheric and may provide more ideal operating conditions for certain electronic components housed within the enclosure.

In one embodiment of the invention, the enclosure may be a pressure compensated enclosure adapted to allow the pressure within the enclosure to be balanced to the pressure outside of the enclosure, e.g. by means of a pressure compensator. This embodiment of the invention may provide an enclosure with reduced wall thickness due to the lower differential pressure and may also provide more ideal operating conditions for certain electronic components housed within the enclosure.

In one embodiment of the invention, the enclosure may be a canister. A canister is advantageous in that it provides a physical barrier separating the outside liquid environment from the electronic component housed inside the canister. Moreover, it provides the surface or surfaces across which heat generated by the electronic component may be transferred to the outside liquid environment.

In one embodiment of the invention, the heat generating electronic component may be a variable speed drive or adjustable speed drive. In particular, the electronic component may be a power electronic component of such variable speed drive.

In one embodiment of the invention, the contact between the non-fluid block and the electronic component as well as the contact between the non-fluid block and an inner surface of the pressure resistant enclosure may be achieved mechanically, such as with the use of etched grooves, nails, fasteners or hooks. The contact may also be achieved through an adhesive such as thermal glue. Both the mechanical connection as well as a connection achieved with adhesive offer the advantage that the non-fluid block remains in a fixed position relative to the electronic component and the pressure resistant enclosure.

According to another embodiment of the invention, the electrically insulating, thermally conductive material is **characterized in that** it features relatively high thermal conductivity, for example at least 50 Wm⁻¹K⁻¹. Preferably, the thermal conductivity of the material is at least 70 Wm⁻¹K⁻¹, more preferably at least 100 Wm⁻¹K⁻¹. Materials that are considered to have relatively high thermal conductivity and that may be used with this embodiment include Aluminum Nitride, Boron Nitride and Aluminum Oxide.

According to another embodiment of the invention, the non-fluid block may be comprised of or may consist of two or more layers. The first layer, adjacent to the heat generating electronic component, may be comprised of or may consist of electrically insulating, thermally conductive material, while the second layer, adjacent to one wall of the enclosure, may be comprised of or may consist of thermal transportation material. Examples of electrically insulating, thermally conductive materials of which the first layer may be comprised or consist include Aluminum Nitride, Boron Nitride and Aluminum Oxide, either alone or in combination with other materials. Examples of thermal transportation materials of which the second layer may be comprised or consist include steel, aluminum, copper and other materials with similar thermal conductivity. Similarly, the thermal transportation materials may be found either alone or in combination with other materials in the second layer.

It is to be understood that the features mentioned above and those yet to be explained below can be used not only in the respective combinations indicated, but also in other combinations or in isolation, without leaving the scope of the present invention.

### Brief Description of the Drawings

The foregoing and other features and advantages of the invention will become further apparent from the following detailed description read in conjunction with the accompanying drawings. In the drawings, like reference numerals refer to like elements.
Figure 1 is a schematic drawing showing a first embodiment of the subsea enclosure system.
Figure 2 is a schematic drawing showing a second embodiment of the subsea enclosure system.

### Detailed Description of the Invention

In subsea applications, heat generated from electronic components is transported by natural convection from the electronic component 1 into the surrounding fluid within the canister. The heat is then transferred across the canister wall 4 into the seawater. As subsea electronic components often carry high currents and high voltages, positioning them directly adjacent to the canister wall for cooling by the cold seawater surrounding the canister may result in a short circuit and is thus not a feasible solution. Consequently, a certain insulation distance is generally required. Rather than a solution based on convective transfer of heat, the solution and invention described herein relies on the conductive transfer of heat through a non-fluid block 2 comprised of a material, in particular a ceramic material, that is also electrically insulating and provides a more efficient and effective method of heat disposal.

Thermal conductivity (k) is the ability of a material to transport thermal energy due to temperature gradient. Examples of materials with high thermal conductivity that are also electrically insulating and that can be used in embodiments of the invention include Aluminum Nitride, Boron Nitride and Aluminum Oxide.

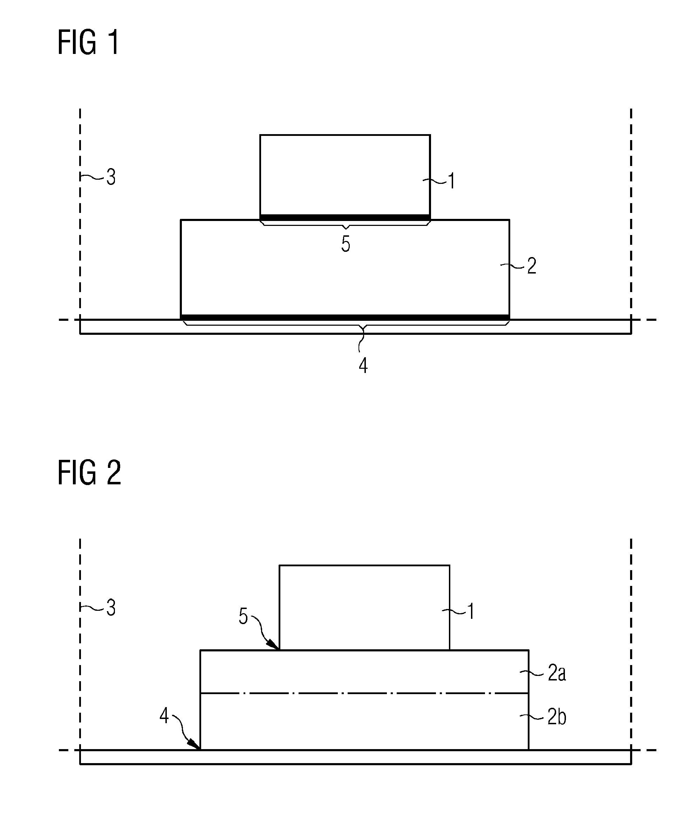

As shown in Figure 1, in one embodiment of the invention a subsea enclosure system is comprised of: an enclosure 3 adapted to maintain a predetermined pressure inside the enclosure when the system is deployed under water; a heat generating electronic component 1 arranged in the enclosure, the electronic component generating heat in operation; a non-fluid block 2 comprised of an electrically insulating, thermally conductive material which is at at least one surface 5 in direct contact with the heat generating electronic component and at another surface 4 in direct contact with the inner surface of at least one wall of the pressure resistant enclosure, so as to enable the non-fluid transfer of heat from the heat generating electronic component to the at least one wall of the enclosure when the subsea enclosure system is deployed under water in an operating state.

As shown in Figure 2, the non-fluid block described in the embodiment above in another embodiment may be comprised of two or more layers, one of which is comprised of an electrically insulating, thermally conductive material 2a, and a second layer comprised of thermal transportation material 2b. The thermal transportation material may be made of a metal, such as steel, aluminum or copper. In this second embodiment, the non-fluid block is positioned such that the layer of electrically insulating, thermally conductive material is adjacent to the heat generating electronic component.

The enclosure may be a pressure resistant enclosure, meaning that the pressure inside the enclosure is relatively constant and independent of deployment depth. The enclosure may thus have relatively thick wall in order to withstand large differential pressures, yet conventional electronic components can be used inside such enclosure. In other embodiments, the enclosure may be a pressure compensated enclosure in which the pressure inside the enclosure is balanced or equalized to the pressure prevailing outside the enclosure, e.g. in the ambient sea water. This can be achieved by providing the enclosure with a pressure compensator and filling the enclosure with a liquid, in particular a dielectric liquid. Pressure tolerant electronic components can be used in such enclosure. The pressure compensated enclosure has the advantage that it only needs to withstand relatively small differential pressures, it may thus be provided with relatively thin walls resulting in a compact and light weight enclosure.

In the above embodiments of the invention, the respective direct contacts between the non-fluid block and the heat generating electronic component and the inner surface of at least one wall of the pressure resistant enclosure can be achieved either through mechanical connection or with use of thermal glue.

In the above embodiments, the thermal conductivity of the electrically insulating, thermally conductive non-fluid material is at least 50 Wm⁻¹K⁻¹. Preferably, the thermal conductivity of the material is at least 70 Wm⁻¹K⁻¹, more preferably at least 100 Wm⁻¹K⁻¹. Examples of materials in this range of thermal conductivity that could be used in the embodiments include Aluminum Nitride, Boron Nitride or Aluminum Oxide either alone or in combination with other materials.

## Claims

1. A subsea enclosure system, comprising:
- an enclosure adapted to maintain a predetermined pressure inside the enclosure when the system is deployed under water;
- a heat generating electronic component arranged in the enclosure, the electronic component generating heat in operation;
- a non-fluid block comprised of an electrically insulating, thermally conductive material which is at at least one surface in direct contact with the heat generating electronic component and at another surface in direct contact with the inner surface of at least one wall of the pressure resistant enclosure, so as to enable the non-fluid transfer of heat from the heat generating electronic component to the at least one wall of the enclosure when the subsea enclosure system is deployed under water in an operating state.

2. The invention as claimed in claim 1, wherein the enclosure is a pressure resistant enclosure adapted to maintain a pressure below 5 bar, preferably substantially atmospheric pressure inside the enclosure.

3. The invention as claimed in claim 1, wherein the enclosure is a pressure compensated enclosure adapted to allow the balancing of the pressure inside the enclosure in relation to the pressure outside of the enclosure.

4. The invention as claimed in any of the preceding claims, wherein the non-fluid block is comprised of two or more layers, a first layer of which is comprised of the electrically insulating, thermally conductive material, a second layer of which is comprised of thermal transportation material, and wherein the non-fluid block is positioned such that the electrically insulating, thermally conductive material is adjacent to the heat generating electronic component.

5. The invention as claimed in claim 4, wherein the layer of thermal transportation material includes a metal.

6. The invention as claimed in claim 4 or 5, wherein the layer of thermal transportation material is composed of a metal.

7. The invention as claimed in any of claims 4-6, wherein the layer of thermal transportation material includes aluminum or copper.

8. The invention as claimed in any of the preceding claims, wherein the direct contacts are achieved through mechanical connection.

9. The invention as claimed in any of the preceding claims, wherein the direct contacts are achieved through etched grooves, nails, fasteners or hooks.

10. The invention as claimed in any of the preceding claims, wherein the direct contacts are achieved through an adhesive.

11. The invention as claimed in any of the preceding claims, wherein the direct contacts are achieved using thermal glue.

12. The invention as claimed in any of the preceding claims, wherein the electrically insulating, thermally conductive material has a thermal conductivity of at least 50 Wm⁻¹K⁻¹.

13. The invention as claimed in any of the preceding claims, wherein the electrically insulating, thermally conductive material has a thermal conductivity of at least 70 Wm⁻¹K⁻¹.

14. The invention as claimed in any of the preceding claims, wherein the electrically insulating, thermally conductive material has a thermal conductivity of at least 100 Wm-¹K-¹.

15. The invention as claimed in any of the preceding claims, wherein the electrically insulating is composed of Aluminum nitride, Boron Nitride or Aluminum Oxide either alone or in combination with other materials.
